# EUROPEAN PATENT APPLICATION

(11) **EP 4 528 758 A1**
(43) Date of publication of application: **26.03.2025**
(21) Application number: 23275133.9
(22) Date of filing: 19.09.2023
(51) Int. Cl.: H01F 6/04, F17C 13/08, F25D 19/00, G01R 33/38

(54) **SUSPENSION ROD AND MAGNET SUPPORT SYSTEM**

(71) Applicant: Siemens Healthcare Limited, Camberley, Surrey GU15 3YL (GB)
(72) Inventor: Mortensen, Anders, Bicester, OX26 6PU (GB)
(74) Representative: Maier, Daniel Oliver

(57) **Abstract**

The invention relates to a suspension rod (12) for suspending a main magnet (17) of a magnetic resonance device (11), comprising a first end, a second end, and a thermal intercept (50) including a thermal link thermally and mechanically connected to the thermal intercept (50), wherein the thermal intercept (50) is configured for thermally connecting the suspension rod (12) to a cold source and wherein the thermal intercept (50) is thermally and mechanically connected to a section of the suspension rod (12) located between the first end and the second end, wherein the thermal link is spaced from the suspension rod (12) along a section of the suspension rod (12) located between the thermal intercept (50) and the second end. The invention also pertains to a magnet support system (31) comprising an inventive suspension rod (12) and a magnetic resonance device (11) comprising an inventive magnet support system (31).

## Description

Independent of the grammatical term usage, individuals with male, female or other gender identities are included within the term.

Magnetic resonance devices typically use cryocoolers to maintain superconducting magnets at a superconducting temperature. The cooling capacities of cryocoolers tend to decrease significantly with decreasing operating temperature of the superconducting magnet. For example, at superconducting temperatures around 4 K, cryocoolers usually have a limited cooling capacity of about 1 W. Thus, it is crucial to minimize any transport of heat energy from a surrounding environment of the magnetic resonance device to the superconducting magnet. For this purpose, the superconducting magnet is commonly shielded from blackbody radiation of components inside a vacuum chamber of the magnetic resonance device via a thermally conductive shield (or thermal shield) held at an intermediate temperature level, e. g. in a range between 40 K and 60 K.

The superconducting magnet and the thermal shield are typically cooled via a single cryocooler comprising a first stage and a second stage. The thermal shield is thermally connected to the first stage of the cryocooler, whereas the superconducting magnet is thermally connected to the second stage of the cryocooler. The temperature level of the first stage of the cryocooler may correspond to the intermediate temperature level. Thus, the first stage usually provides significantly higher cooling capacities than the second stage of the cryocooler, which is configured to remove heat energy at the temperature level of the superconducting temperature.

With the introduction of conduction-cooled or "dry" magnetic resonance devices, the superconducting magnet is no longer enclosed by a cryogen vessel comprising a liquid volume of cryogen wherein the superconducting magnet is at least partially immersed. The superconducting magnets in "dry" magnetic resonance devices can be suspended directly off an outer vacuum vessel using a plurality of suspension rods. These suspensions rods need to have a small cross-sectional area and low thermal conductivity to minimize a transport of heat energy in the direction of the superconducting magnet. However, the suspension rods must also be strong enough to bear the weight of the superconducting magnet as well as electromagnetic forces acting on the superconducting magnet during ramping and operation of the magnetic resonance device.

It is an objective of the invention to improve a thermal design of a magnetic resonance device.

This objective is achieved by a suspension rod and a magnet support system according to the invention. Further advantageous embodiments are specified in the dependent claims.

The inventive suspension rod for suspending a main magnet of a magnetic resonance device comprises a first end, a second end and a thermal intercept including a thermal link thermally and mechanically connected to the thermal intercept.

Preferably, the suspension rod consists of a material with high tensile strength. Examples for suitable materials are metals, particularly stainless steel, or composite materials, such as fibre reinforced plastics, and the like. According to an embodiment, a shaft of the suspension rod comprises carbon fibres. For example, the shaft of the suspension rod may consist of a carbon fibre reinforced polymer.

The suspension rod may have a cylindrical or a prismatic shape. For example, the suspension rod may correspond to a pole or bar comprising an oval or polygonal cross-section. Preferably, the suspension rod has an elongated or oblong shape.

The first end and the second end of the suspension rod may each comprise an anchor or ferrule. The anchor or ferrule may be attached to the suspension rod via an arbitrary mechanical connection, such as a form-locking connection, a force-locking connection and/or a material bond. For example, the anchor or ferrule may be clamped, wedged and/or glued to the suspension rod. However, any suitable mechanical connection may be used.

The thermal intercept may represent a thermal connection, a thermal junction, or a thermal joint. The thermal intercept is thermally and mechanically connected to the suspension rod. For example, the thermal intercept may comprise a thermally conductive element attached to the suspension rod. The thermally conductive element may represent a bracket, a clamp, a tube, a ring, a sleeve, or any suitable connector. The thermally conductive element may be mechanically connected to the suspension rod via a force-locking connection, a form-locking connection and/or a material bond. For example, the thermally conductive element may be clamped, swaged, or crimped onto the suspension rod. It is also conceivable, that the thermally conductive element is attached to the suspension rod via an adhesive, particularly a thermally conductive adhesive. Preferably, the thermally conductive element comprises or consists of a thermally conductive material, for example a metal and/or a thermally conductive composite material.

The thermal intercept includes a thermal link which is thermally and mechanically connected to the thermal intercept. It is conceivable, that the thermal link forms part of the thermal intercept and/or the thermally conductive element. However, the thermal link may also represent a separate component thermally and mechanically connected to the thermal intercept and/or the thermally conductive element. In a preferred embodiment, the thermally conductive element and/or the thermal link may comprise or consist of a tubular thermal conductor and/or a flexible thermal conductor.

The thermal intercept is configured for thermally connecting the suspension rod to a cold source. Particularly, the thermal intercept may be configured to absorb heat energy from the suspension rod and transfer the heat energy to a cold source thermally and mechanically connected to the thermal link. The cold source may be any component connected to a cooling stage of a cryocooler, e. g. a thermal shield or a component of the magnet support system, but also the cooling stage of the cryocooler itself.

According to the invention, the thermal intercept is thermally and mechanically connected to a section of the suspension rod located between the first end and the second end. Preferably, a distance between the thermal intercept and the first end of the suspension exceeds a distance between the thermal intercept and the second end of the thermal intercept. It is conceivable that a distance between the thermal intercept and the second end of the suspension rod is at least 10 cm, at least 15 cm, at least 20 cm, at least 30 cm, or at least 40 cm.

The thermal link is spaced from the suspension rod along a section of the suspension rod located between the thermal intercept and the second end. For example, the thermal link is kept at a distance from the suspension rod along the section of the suspension rod located between the thermal intercept and the second end. The thermal link may also be guided or routed at a distance from the suspension rod along the section of the suspension rod located between the thermal intercept and the second end. Preferably, the thermal link is kept at a distance of at least 0,5 mm, at least 1 mm, or at least 2 mm from the shaft of the suspension rod along the section of the suspension rod located between the thermal intercept and the second end. The distance between the thermal link and the shaft of the suspension rod may vary along the section of the suspension rod located between the thermal intercept and the second end. According to an embodiment, a contact between the thermal link and the shaft of the suspension rod along the section of the suspension rod located between the thermal intercept and the second end is avoided. In a preferred embodiment, a thermally insulating material is disposed between the thermal link and the shaft of the suspension rod. The thermally insulating material may be configured to space or separate the thermal link from the suspension rod, but also to maintain a distance between the thermal link and the suspension rod.

In a preferred embodiment of the inventive suspension rod, the thermal link comprises a flexible thermal conductor.

A flexible thermal conductor may be plastically or elastically deformable. Particularly, the flexible thermal conductor may be manually deformable. It is conceivable that the flexible thermal conductor needs to be bent and/or deformed when installing the suspension rod into an inventive magnet support system. Particularly, the flexible thermal conductor may allow for circumventing obstacles or components of the magnet support system when mechanically connecting the thermal link to a cold source, such as a thermal shield. It is also conceivable that the flexible thermal conductor is configured to be routed around bends or corners, preferably while the suspension rod is attached to a main magnet (or a support structure supporting the main magnet) and an outer vacuum chamber of the magnet support system according to an embodiment described below.

In providing a suspension rod comprising a flexible thermal conductor, an effort of installing the suspension rod in a magnet support system, but also a risk of damaging components of the magnet support system during the installation, may favourably be reduced.

According to an embodiment of the inventive suspension rod, the flexible thermal conductor comprises a flexible metal fabric, such as a metal braid, a metal mesh, or a metal weave. The flexible metal fabric may comprise or consist of a metal with a high thermal conductivity, such as copper, gold, aluminium, platinum, silver, or the like. However, it is also conceivable that the flexible thermal conductor comprises a thermally conductive composite material. In a preferred embodiment, the flexible thermal conductor consists of a copper braid.

A thermal link comprising a flexible thermal conductor may favourably allow for thermally connecting the suspension rod to a cold source spatially separated or spaced from the thermal intercept. Furthermore, a flexible thermal conductor can be guided or routed around an obstacle, such as a corner or a component of a magnet support system. Thus, thermally connecting individual suspension rods to a cold source in a complex three-dimensional arrangement of a magnet support system may favourably be facilitated.

The thermal intercept favourably allows for tuning of a thermal performance of the inventive suspension rod, e. g. by modifying or optimizing a position of the thermal intercept along the suspension rod. Thus, a temperature distribution of the suspension rod and/or a transport of heat energy along the suspension rod can be tuned independent of a position of the cold source, but also under consideration of thermal design constraints of the magnet support system.

Furthermore, the inventive suspension rod allows for arranging the thermal intercept closer to the first end of the suspension rod. Thus, the inventive suspension rod may favourably allow for a reduction of a space required to be enclosed by an outer vacuum chamber of a magnetic resonance device, but also a dimension of the outer vacuum chamber.

According to an embodiment of the inventive suspension rod, a section of the suspension rod located between the thermal intercept and the second end is wrapped in a thermally insulating material.

A thermally insulating material may be any material with a low thermal conductivity, for example a thermal conductivity of less than 1 ***W*/(*m*·*K*),** less than 0.5 ***W*/(*m*·*K*),** or less than 0.1 ***W*/(*m*·*K*),** at a temperature level below 100 K. Preferably, the thermally insulating material has a low emissivity (i. e. effectiveness in emitting energy as thermal radiation), e. g. ranging between 0,01 and 0,05. Suitable thermally insulating materials may be polymers or plastics, such as polyethylene, polyurethane, polyimide (i. e. Kapton), but also carbon, carbon composites, silica composites, and the like. The section of the suspension rod located between the thermal intercept and the second end may be wrapped in a fabric of thermally insulating material. For example, the suspension rod may be wrapped in a sheet comprising the thermally insulating material.

In one embodiment, the thermally insulating material comprises a multilayer insulation. The multilayer insulation may be wrapped around the section of the suspension rod located between the thermal intercept and the second end. The multilayer insulation (MLI) may consist of several layers (multilayer) of metal-vaporized plastic foils, which are kept at a distance by spacers. For example, the foils may consist of a polyester or polyimide sheet which is aluminised on both sides. The spacers may consist of woven or non-woven sheets or gauzes made from polyester or polyimide. MLI may be used to reflect thermal radiation from the outer vacuum chamber, and to establish a stable thermal gradient between the outer vacuum chamber and the thermal shield.

By wrapping a section of the suspension rod in a thermally insulating material, a high share of blackbody radiation emitted by the suspension rod may be prevented from reaching other components of the magnet support system. Thus, a transport of heat energy in the direction of the main magnet may favourably be reduced or minimized.

In an embodiment of the inventive suspension rod, a thermally insulating material is disposed between the thermal link and the suspension rod.

The thermally insulating material may correspond to a thermally insulating material described above. In a preferred embodiment, the thermally insulating material comprises MLI blankets wrapped around the suspension rod. It is conceivable that the thermally insulating material acts as a spacer separating the thermal link from the suspension rod along a section of the suspension rod. The thermally insulating material may also be configured to mechanically support the thermal link in a predefined relative position to the suspension rod.

A thermally insulating material disposed between the suspension rod and the thermal link may favourably reduce an emission of thermal radiation, but also prevent the thermal link from contacting the suspension rod along a section of the suspension rod.

According to an embodiment of the inventive suspension rod, the thermal link comprises tubular thermal conductor circumferentially encompassing the suspension rod along a section of the suspension rod located between the thermal intercept and the second end.

The tubular thermal conductor may form a part of the thermal intercept and/or the thermal link. For example, the tubular thermal conductor may be thermally and mechanically connected to the thermal intercept according to an embodiment described above.

Preferably, the tubular thermal conductor is made of a rigid material. The tubular thermal conductor may circumferentially encompass the suspension rod along a section of the suspension rod located between the thermal intercept and the second end. Particularly, a diameter of the tubular thermal conductor may exceed a diameter of the suspension rod and thus provide a distance between the thermal link and the suspension rod. According to an embodiment, the tubular thermal conductor is thermally and mechanically connected to the suspension rod at the location of the thermal intercept but spaced from the shaft of the suspension rod along a section of the suspension rod located between the thermal intercept and the second end.

The tubular thermal conductor may exhibit an oval, a circular, or a polygonal cross-section.

A material of the tubular thermal conductor may correspond to a material of the flexible thermal conductor. In a preferred embodiment, the tubular thermal conductor consists of a highly conductive metal, such as copper, gold, aluminium, platinum, silver, or the like.

In providing a tubular thermal conductor, the thermal link can be securely kept at a distance from the suspension rod over a predefined length of the suspension rod. Furthermore, a rigid tubular thermal conductor may provide a particularly compact and/or robust solution for thermally connecting the thermal intercept to a cold source while separating the thermal link from the shaft of the suspension rod along the section of the suspension rod located between the thermal intercept and the second end.

According to a preferred embodiment of the inventive suspension rod, the tubular thermal conductor is mechanically connected to the thermal intercept or forms a part of the thermal intercept, and the flexible thermal conductor is mechanically connected to the tubular thermal conductor.

The tubular thermal conductor and the flexible thermal conductor may be embodied as described above. The flexible thermal conductor may be thermally and mechanically connected to the tubular thermal conductor. For example, the flexible thermal conductor may be attached to the tubular thermal conductor using a pin, a screw, a bolt, a clamp, a rivet, or the like. Alternatively or additionally, the flexible thermal conductor may be soldered to the tubular thermal conductor. It is also conceivable that the flexible thermal conductor is attached to the tubular thermal conductor via a thermally conductive adhesive. Preferably, the flexible thermal conductor is attached to an end of the tubular thermal conductor facing towards the second end of the suspension rod.

The tubular thermal conductor and the flexible thermal conductor may form parts of the thermal link.

In providing a thermal link comprising a tubular thermal conductor and a flexible thermal conductor mechanically connected to the tubular thermal conductor, a compact thermal intercept may be provided, which may still allow for a flexible thermal connection to a cold source spaced at a distance from the thermal intercept.

According to an embodiment, the inventive suspension rod comprises a collar configured for deflecting thermal radiation. The collar circumferentially encompasses the suspension rod along a section of the suspension rod located between the thermal intercept and the second end.

In a preferred embodiment, the collar encompasses the suspension rod and the thermal link, particularly the tubular thermal conductor, along a section of the suspension rod located between the thermal intercept and the second end of the suspension rod.

The collar may comprise a tapered section along an axial direction of the suspension rod. The tapered section may be oriented towards the second end of the suspension rod. Thus, a first diameter of a section of the of the collar located closer to the first end of the suspension rod may exceed a second diameter of a section of the collar located closer to the second end of the suspension rod. For example, the collar may be shaped as a cone, a frustrum, a hemisphere, or the like. In particular, the collar may be configured to abut against a thermal shield and/or cover a hole or passage in a thermal shield of a magnet support system according to an embodiment described below. It is also conceivable, however, that the collar comprises a disk shape.

The collar may comprise a support element wrapped in a thermally insulating material according to an embodiment described above. For example, the support element may be wrapped in a multilayer insulation. However, the collar may also consist of a thermally insulating material according to an embodiment described above. In a preferred embodiment, the collar is configured to deflect or block thermal radiation.

In a preferred embodiment, the collar is mechanically connected to the tubular thermal conductor. Particularly, the tubular thermal connector may be configured to provide mechanical support to the collar. For example, the collar may be taped, glued, or soldered to the tubular thermal conductor. Preferably, the collar is attached to the suspension rod and/or the tubular thermal conductor in such a way, that thermal radiation is prevented from passing through an interfacial region between the collar and the tubular thermal conductor and/or the suspension rod.

An inventive suspension rod comprising a collar may favourably prevent thermal radiation from passing through a hole or passage in a thermal shield providing a conduct for the suspension rod. In providing a collar having a tapered shape along an axial direction of the suspension rod, manufacturing tolerances of the suspension rod and/or the magnet support system may favourably be compensated.

The inventive magnet support system comprises a suspension rod according to an embodiment described above, a main magnet, a thermal shield, and an outer vacuum chamber.

The main magnet may comprise or consist of one or more electromagnets or superconducting magnets. In a preferred embodiment, the main magnet comprises or consists of one or more solenoidal or cylindrical superconducting magnets or superconducting coils. The main magnet may comprise a dedicated support structure configured to carry the main magnet and/or provide support to the main magnet. The term "main magnet" as used herein may comprise one or more solenoidal superconducting coil as well as a dedicated support structure.

The thermal shield may be configured to reduce a transport of heat energy to the main magnet. A transport of heat energy may be characterized by a heat transport mechanism such as thermal radiation, heat conduction, but also heat convection. The thermal shield may circumferentially encompass the main magnet. For example, the thermal shield may form a vessel enclosing the main magnet. In a preferred embodiment, the thermal shield comprises an outer wall, an inner wall and annular end walls connecting the outer wall and the inner wall. Particularly, the thermal shield may form a double-walled hollow cylinder enclosing the main magnet between the outer wall, the inner wall and the annular end walls. A cylinder axis of the thermal shield may be oriented in parallel to or correspond an axis of rotational symmetry defined by the solenoidal coil of the main magnet.

Preferably, the thermal shield comprises or consists of a material with high electrical and/or high thermal conductivity. For example, the thermal shield may consist of copper or aluminium, particularly a copper alloy or an aluminium alloy. The thermal shield may also comprise gold, platinum, silver, or other materials with high thermal conductivity. In one embodiment, the thermal shield is coated or galvanized with gold, platinum, or other metals with high thermal conductivity.

The thermal shield may comprise a continuous or coherent surface. In an alternative embodiment, the thermal shield may comprise or consist of a plurality of spaced shield elements or rings. The thermal shield may further comprise one or more sections of coiled wire.

In a preferred embodiment, the thermal shield is shaped in such a way to conform to a shape of the main magnet. For example, a surface contour of the thermal shield may imitate or conform to a surface contour of the main magnet.

In a preferred embodiment, the thermal shield corresponds to a 50K shield of a magnetic resonance device.

The outer vacuum chamber may form a vessel which is substantially impermeable to fluids, such as a liquid or a gaseous cryogen. The vacuum chamber may be configured to maintain a vacuum in an inner volume encompassed by the vacuum chamber. Preferably, the outer vacuum chamber encompasses other components of the magnet support system, such as a cryogen vessel, the thermal shield, a further thermal shield, and the main magnet. According to an embodiment, the outer vacuum chamber comprises an outer shell, an inner shell and annular end walls connecting the outer shell and the inner shell. Particularly, the outer vacuum chamber may form a double-walled hollow cylinder enclosing the main magnet and the thermal shield between the outer shell, the inner shell and the annular end walls. A cylinder axis of the outer vacuum chamber may be oriented in parallel to or correspond an axis of rotational symmetry defined by the solenoidal coil of the main magnet. The inner shell of the outer vacuum chamber may correspond to a patient bore of a magnetic resonance device.

In a preferred embodiment, the outer vacuum chamber is configured to provide mechanical support to the suspension rod and the main magnet. The outer vacuum chamber may also be configured to provide mechanical support to the thermal shield and/or a further thermal shield. For example, the thermal shield and/or the further thermal shield may be suspended from the outer vacuum chamber.

According to the invention, the first end of the suspension rod is mechanically connected to the main magnet and the second end of the suspension rod is mechanically connected to an outer wall of the outer vacuum chamber.

As described above, the first end and/or the second end of the suspension rod may comprise an anchor or a ferrule. The anchor or ferrule at the first end of the suspension rod may be configured to mechanically engage with the main magnet. Likewise, the anchor or ferrule at the second end of the suspension rod may be configured to mechanically engage with the outer vacuum chamber. Thus, the suspension rod may be held under tension when mechanically connected to the main magnet and the outer vacuum chamber. The suspension rod may be mechanically connected to the main magnet and the outer vacuum chamber via any suitable mechanical connection. For example, the suspension may be screwed, clamped, and/or bolted to the main magnet (or a support structure supporting the main magnet). It is also conceivable that the suspension rods are mechanically connected to the main magnet via hooks.

The suspension rod is routed through a passage in the thermal shield. The passage in the thermal shield may represent a hole, a bore, a slot, or a cavity extending through a material or wall of the thermal shield. The suspension rod may pass through the passage in the thermal shield to provide a mechanical connection between the main magnet and the outer vacuum chamber.

The thermal intercept is mechanically connected to a section of the suspension rod located between the first end of the suspension rod and the thermal shield.

It is conceivable that the thermal intercept and the thermal shield are spaced apart along an axis of the suspension rod. For example, a distance between the thermal intercept and the thermal shield may correspond to a length of a section of the suspension rod. Preferably, the length of the section of the suspension rod defining the distance between the thermal intercept and the thermal shield exceeds 3 cm, 5 cm, 10 cm, 15 cm, or 20 cm. In some embodiments, however, the distance between the thermal intercept and the thermal shield may be less than 5 cm. In a preferred embodiment, a distance between the first end of the suspension rod and the thermal shield exceeds a distance between the first end of the suspension rod and the thermal intercept.

According to the invention, the thermal intercept is mechanically and thermally connected to the thermal shield via the thermal link.

The thermal link may be configured to bridge a distance between the thermal intercept and the thermal shield. Particularly, the thermal link may provide a thermal and mechanical connection between the thermal intercept and the thermal shield.

In a preferred embodiment, the thermal shield is thermally connected to a cryocooler, particularly a first stage of a cryocooler. Thus, the suspension rod may be thermally connected to the cryocooler via the thermal intercept, the thermal link, and the thermal shield.

The inventive magnet support system shares the advantages of the inventive suspension rod. Particularly, the thermal intercept of the inventive magnet support system may be located far within a volume enclosed by the thermal shield without significantly increasing a heat load onto the main magnet from a surrounding environment. The inventive magnet support system may also reduce or offset limitations, particularly geometric restrictions, related to providing a thermal connection between the suspension rod and the thermal shield, especially in presence of a further thermal shield.

According to an embodiment, the inventive magnet support system comprises a further thermal shield arranged between the main magnet and the thermal shield.

The further thermal shield may form a vessel comprising an outer wall, an inner wall and annular end walls connecting the outer wall and the inner wall. Particularly, the further thermal shield may form a double-walled hollow cylinder enclosing the main magnet between the outer wall, the inner wall, and the annular end walls of the further thermal shield. A cylinder axis of the further thermal shield may be oriented in parallel to or correspond to an axis of rotational symmetry defined by the solenoidal coil of the main magnet.

The further thermal shield may be an intermediate thermal shield. For example, the further thermal shield may be maintained at a temperature level between 4K and 50 K. It is conceivable that the further thermal shield is configured to prevent heat energy, particularly thermal radiation, from entering a region of the magnet support system enclosed by the further thermal shield (e. g. a region enclosed between the outer wall and the inner wall of the further thermal shield).

The further thermal shield may comprise or consist of coated or galvanized plastic or polymer. For example, the further thermal shield may consist of an aluminized plastic, such as polyethylene terephthalate (PET), or the like. In certain embodiments, the plastic or polymer may be coated, plated, or laminated with any thermally conductive metal, such as gold, silver, copper, or platinum. Preferably, the further thermal shield has a low emissivity, e. g. below 0.1 or below 0.05. The suspension rod is routed through a passage in the further thermal shield. Preferably, the suspension rod extends through the thermal shield and the further thermal shield.

The suspension rod may extend through a hole, a bore, or a cavity in the further thermal shield to provide a mechanical connection between the main magnet and the outer vacuum chamber.

In providing an inventive magnet support system comprising a further thermal shield, a share of thermal radiation entering a region or volume directly surrounding the main magnet may be reduced or minimized. Thus, a cooling capacity required for cooling the main magnet may favourably be decreased. In case the thermal intercept comprises a tubular thermal conductor and a flexible thermal conductor, the tubular thermal conductor may favourably be routed through the further thermal shield, while the flexible thermal conductor facilitates a process of thermally connecting the thermal intercept to the thermal shield. Thus, an assembly of the magnet support system may be facilitated and/or a risk of damaging the further thermal shield during assembly may be reduced.

In a further embodiment, the inventive magnet support structure comprises a suspension rod including a collar according to an embodiment described above. The collar is configured to abut against the further thermal shield and cover a gap between the further thermal shield and the suspension rod.

The collar may be embodied as described above. In a preferred embodiment, a location of the collar along the suspension rod may substantially correspond to a location of the further thermal shield along the suspension rod.

As described above, the collar may comprise a tapered section. According to an embodiment, the tapered section has a first diameter smaller than a diameter of the passage in the further thermal shield and a second diameter exceeding the diameter of the passage in the further thermal shield. Thus, the collar may form a plug configured for plugging or occluding the passage in the further thermal shield when the suspension rod is installed in the magnet support system an intended relative position with respect to the further thermal shield.

The collar may also be shaped as a disk. In this case, the collar may be configured to abut against the further thermal shield, thus occluding or covering any potential gap between the passage in the further thermal shield and the suspension rod.

In providing an inventive magnet support system including a suspension rod comprising a collar, an amount of thermal radiation passing through a gap or interfacial region between the suspension rod and the further thermal shield may be reduced or minimized. Thus, a cooling capacity required for maintaining the main magnet at a superconducting temperature may favourably be decreased.

In a preferred embodiment of the inventive magnet support structure, the thermal intercept is mechanically connected to a section of the suspension rod located between the first end of the suspension rod and the further thermal shield.

It is conceivable that a distance between the main magnet and the thermal intercept exceeds a distance between the thermal intercept and the further thermal shield. Preferably, the thermal intercept is mechanically connected to a section of the suspension rod located within a region enclosed by the further thermal shield.

The thermal intercept is thermally and mechanically connected to the thermal shield via the thermal link. Thus, the thermal link may extend through the passage in the further thermal shield. Preferably, the thermal link is spaced or separated from the suspension rod along a section of the suspension rod extending from the thermal intercept to a section of the suspension rod located between the further thermal shield and the thermal shield. According to an embodiment, the thermal link is kept at a distance from the suspension rod along the section of the suspension rod extending from the thermal intercept to the section of the suspension rod located between the further thermal shield and the thermal shield.

In providing a magnet support system with a suspension rod comprising a thermal intercept encompassed by the further thermal shield, heat energy transported in the direction of the main magnet along the suspension rod can be efficiently absorbed via the thermal intercept and transported to the cold source via the thermal link. Thus, a required cooling capacity for cooling the main magnet may favourably be reduced or minimized. The inventive suspension rod may favourably allow for the thermal intercept to be located within a region enclosed by the further thermal shield, while still providing a thermal and mechanical connection between the thermal intercept and the thermal shield via the thermal link. Thus, a space required to be enclosed by the outer vacuum chamber, but also a dimension of the outer vacuum chamber, may favourably be reduced.

According to a further embodiment of the inventive magnet support system, a section of the suspension rod located between the thermal intercept and the second end is wrapped in a thermally insulating material. The section of the suspension rod wrapped in the thermally insulating material passes through the passage in the thermal shield.

According to a preferred embodiment of the inventive magnet support system, the section of the suspension rod wrapped in the thermally insulating material passes through the passage in the further thermal shield.

The thermally insulating material may be embodied as described above. Preferably, the thermally insulating material comprises or consists of a multilayer thermal insulation, particularly multiple layers of polyimide films or polyimide sheets.

In providing a magnet support structure comprising a suspension rod wrapped in a thermally insulating material, a share of thermal radiation or blackbody radiation emitted via the suspension rod may favourably be deflected and/or prevented from reaching the main magnet.

In an alternative embodiment, the section of the suspension rod wrapped in the thermally insulating material passes through the passage in the further thermal shield but not through the passage in the thermal shield.

The inventive magnetic resonance device comprises a field generation unit including a magnet support system according to an embodiment described above and at least one cryocooler.

The at least one cryocooler is configured for cooling components of the magnetic resonance device. For example, the at least one cryocooler may be configured for cooling the main magnet, the thermal shield, a further thermal shield, a cryogen vessel, and the like.

The at least one cryocooler may be configured to provide a temperature close to or lower than a superconducting temperature of a superconducting material of the main magnet. For example, a superconducting temperature of the main magnet may be in the range of 3 K to 100 K, preferably in the range of 3 K to 6 K, 5 K to 10 K, 30 K to 60 K, or 60 K to 90 K. The at least one cryocooler may be implemented as a pulse tube refrigerator, a Gifford-McMahon refrigerator, a Stirling cryocooler, a Joule-Thomson cryocooler, or the like.

According to the invention, the at least one cryocooler is thermally connected to the main magnet and the thermal shield and configured to maintain the main magnet and the thermal shield at different temperature levels.

The at least one cryocooler may comprise a cold head with one or more cooling stages. In case the cold head comprises multiple cooling stage, each cooling stage may have a different temperature level. It is also conceivable, however, that the inventive magnetic resonance device comprises a first cryocooler configured for cooling the main magnet, and a second cryocooler configured for cooling the thermal shield.

According to an embodiment, the at least one cryocooler comprises at least a first cooling stage and a second cooling stage. The first cooling stage is thermally and mechanically connected to the thermal shield. The second stage is thermally and mechanically connected to the main magnet. Preferably, a temperature level of the first cooling stage exceeds a temperature level of the second stage.

The inventive magnetic resonance device may represent a "dry" system comprising a minimum of cryogen or no cryogen at all. For example, the inventive magnetic resonance system may comprise one or more small cryogen vessels thermally connected to the main magnet via a solid thermal conductor. The small cryogen vessels may contain a volume of less than 10 l, less than 5 l, or less than 1 l of cryogen. In an embodiment of the inventive magnetic resonance device, a cryogen vessel is omitted. Thus, the main magnet may be cooled entirely via thermal conduction.

It is conceivable that the components of the magnetic resonance device, such as the main magnet, the thermal shield, the further thermal shield, one or more suspension rods and/or a cryogen vessel, are thermally connected to the at least one cryocooler, preferably via a solid thermal conductor, a convection loop and/or a heat pipe.

As described above, the thermal shield may be configured for reducing a transport of heat energy to the main magnet. Preferably, the thermal shield is configured to prevent thermal radiation from reaching the main magnet. According to an embodiment, the thermal shield forms a double-walled hollow cylinder. An outer wall of the thermal shield may be configured to block or deflect incoming thermal radiation from a direction of a surrounding environment, while an inner wall of the thermal shield may be configured to block or deflect incoming thermal radiation from a direction of a patient bore of the magnetic resonance device. A surface of the thermal shield directed away from the main magnet may be wrapped in MLI. The magnetic resonance device may comprise a further thermal shield comprising an outer wall and an inner wall configured to block or deflect incoming thermal radiation from the surrounding environment and the patient bore in a similar fashion.

In a preferred embodiment, the thermal shield is thermally and mechanically connected to the cryocooler and configured for transporting heat energy from the thermal shield to the cryocooler via thermal conduction.

According to an embodiment, the thermal shield is configured to block thermal radiation from a direction of the outer shell, the inner shell, and the annular end walls of the outer vacuum chamber.

Preferably, the main magnet is cooled exclusively via thermal conduction. However, the magnetic resonance device may still comprise a cryogen vessel comprising a cryogen thermally connected to the main magnet. According to an embodiment, the inventive magnetic resonance device comprises a cryogen vessel containing a cryogen, wherein the cryogen vessel is thermally connected to the main magnet via a solid thermal conductor.

The cryogen vessel may be configured for storing or preserving a fluid, particularly a cryogen, at a predefined temperature level. Preferably, the fluid or cryogen exhibits a low boiling point, such as Argon, Nitrogen, Neon, Helium, or the like. The predefined temperature level may substantially correspond to a superconducting temperature of the main magnet.

The components of the magnetic resonance device, particularly the outer vacuum chamber, may comprise a thermal insulation configured for reducing a transport of heat energy from the surrounding environment of the magnetic resonance device in the direction of the main magnet. According to an embodiment, the outer vacuum chamber forms a double-walled hollow cylinder. An outer shell and an inner shell of the outer vacuum chamber may be configured for reducing an amount of heat radiation from entering an inner volume of the outer vacuum chamber. The outer vacuum chamber may enclose other components of the cryostat, such as the cryogen vessel, the thermal shield, the further thermal shield, the main magnet, and the suspension rod, between the outer shell and the inner shell.

In a preferred embodiment, the main magnet is suspended from the outer shell of the outer vacuum chamber via a plurality of suspension rods.

The inventive magnetic resonance device shares the advantages of the inventive magnet support system and the inventive suspension rod.

Further advantages and details of the present invention may be recognized from the embodiments described below as well as the drawings. The figures show:
- Fig. 1: a schematic representation of an embodiment of an inventive magnetic resonance device,
- Fig. 2: a schematic representation of an embodiment of an inventive magnetic resonance device,
- Fig. 3: a schematic representation of an embodiment of an inventive magnet support system,
- Fig. 4: a schematic representation of an embodiment of an inventive suspension rod,
- Fig. 5: a schematic representation of an embodiment of an inventive suspension rod,
- Fig. 6: a schematic representation of an embodiment of an inventive suspension rod.

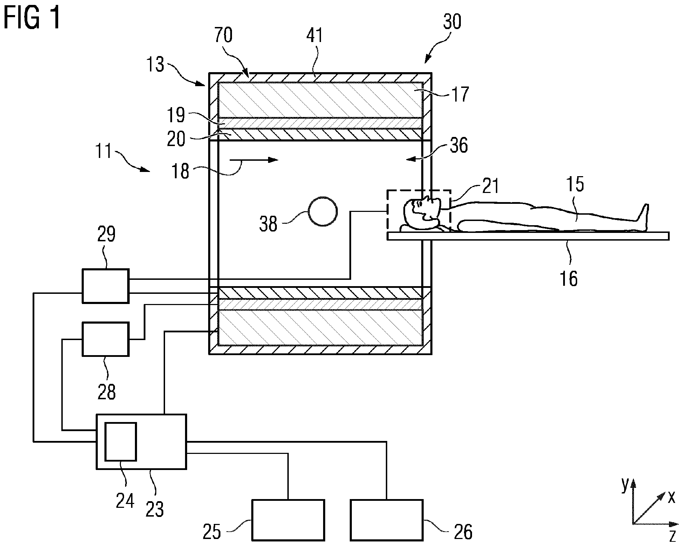

Fig. 1 shows an embodiment of a magnetic resonance device 11 according to the invention. In the illustrated example, the magnetic resonance device 11 comprises a static field magnet 17 or main magnet configured to provide a homogenous, static magnetic field 18 (B0 field) comprising an isocentre 38. The static magnetic field 18 permeates a cylindrical imaging region 36 configured for receiving an imaging object, such as a patient 15. The imaging region 36 may substantially correspond to a volume of a patient bore configured for accommodating a patient during a magnetic resonance measurement. The imaging region 36 is encompassed by the field generation unit 30 in a circumferential direction.

In the depicted example, the magnetic resonance device 11 comprises a patient support 16 configured to transport the patient 15 into the imaging region 36. The patient support 16 may transport a diagnostically relevant body region of the patient 15 into an imaging volume defined by the isocentre 38 of the magnetic resonance device 11. Typically, the field generation unit 30 of the magnetic resonance device 11 is concealed in a housing 41.

The magnetic resonance device 11 may comprise a gradient system 19 configured to provide magnetic gradient fields used for spatial encoding of magnetic resonance signals acquired during a magnetic resonance measurement. The gradient system 19 is activated or controlled by a gradient controller 28 via an appropriate current signal. It is conceivable that the gradient system 19 comprises one or more gradient coils for generating magnetic gradient fields in different, preferably orthogonally oriented, spatial directions.

The magnetic resonance device 11 may comprise an integrated radiofrequency antenna 20 (i. e. a body coil). The radiofrequency antenna 20 is operated via a radiofrequency controller 29 that controls the radiofrequency antenna 20 to generate a high frequency magnetic field and emit radiofrequency excitation pulses into the imaging region 36. The magnetic resonance device 11 may further comprise a local coil 21, which is positioned on or in proximity to the diagnostically relevant region of the patient 15. The local coil 21 may be configured to emit radiofrequency excitation pulses into the patient 15 and/or receive magnetic resonance signals from the patient 15. It is conceivable, that the local coil 21 is controlled via the radiofrequency controller 29.

The magnetic resonance device 11 further comprises a control unit 23 configured for controlling the magnetic resonance device 11. The control unit 23 may comprise a processing unit 24 configured to process magnetic resonance signals and reconstruct magnetic resonance images. The processing unit 24 may also be configured to process input from a user of the magnetic resonance device 11 and/or provide an output to a user. For this purpose, the processing unit 24 and/or the control unit 23 can be connected to a display unit 25 and an input unit 26 via a suitable signal connection. For a preparation of a magnetic resonance measurement, preparatory information, such as imaging parameters or patient information, can be provided to the user via the display unit 25. The input unit 26 may be configured to receive information and/or imaging parameters from the user.

Of course, the magnetic resonance device 11 may comprise further components that magnetic resonance devices usually offer. The general operation of a magnetic resonance device 11 is known to those skilled in the art, so a more detailed description is omitted.

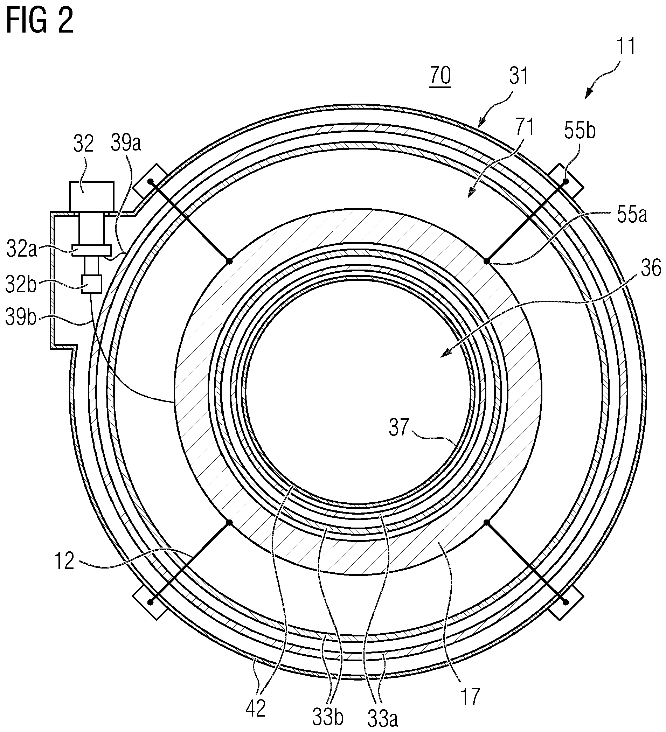

Fig. 2 shows a sectional view of the inventive magnetic resonance device 11 according to Fig. 1. In the depicted example, the outer vacuum chamber 42 provides an outer enclosure for the components of the magnet support system 31. Particularly, the outer vacuum chamber 42 separates a surrounding environment 70 from a vacuum region 71 encompassed by the outer vacuum chamber 42. The outer vacuum chamber 42 may represent a double-walled hollow cylinder comprising an outer shell and an inner shell. Other components of the magnet support system 31 may be housed within or enclosed between the outer shell and the inner shell of the outer vacuum chamber 42. The inner shell of the outer vacuum chamber 42 may provide a patient bore 37 enclosing the imaging region 36 in a circumferential direction.

The magnet support system 31 may further comprise a thermal shield 33a and a further thermal shield 33b. Both the thermal shield 33a and the further thermal shield 33b may be embodied as double-walled hollow cylinders having end walls (not shown) according to an embodiment described above. For example, the further thermal shield 33b and the main magnet 17 may be enclosed between an outer wall and an inner wall of the thermal shield 33a. Likewise, the main magnet 17 may be enclosed between an outer wall and an inner wall of the further thermal shield 33b.

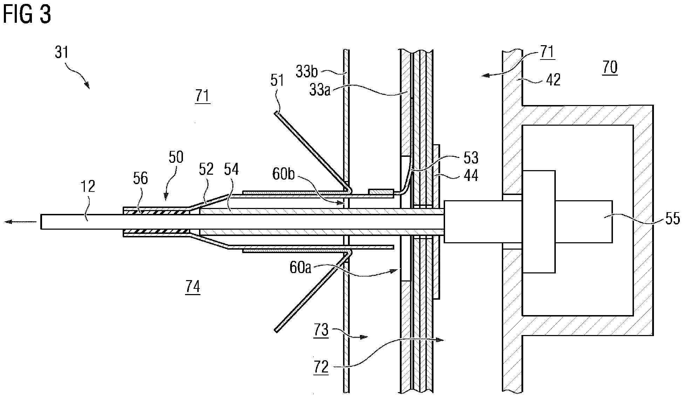

The magnet support system 31 comprises one or more suspension rods 12 mechanically connected to the outer vacuum chamber 42 and the main magnet 17. In the depicted example, the suspension rods 12 extend through passages 60a in the thermal shield 33a and passages 60b in the further thermal shield 33b (see Fig. 3) to provide a mechanical connection between the outer vacuum chamber 42 and the main magnet 17.

The magnetic resonance device 11 further comprises a cryocooler 32 mounted on the outer vacuum chamber 42. The cryocooler 32 may be configured to cool the main magnet 17, the thermal shield 33a, the further thermal shield 33b, but also other components of the field generation unit 30, such as a cryogen vessel (not shown).

The cryocooler 32 typically comprises a compressor supplying pressurized gas to the cryocooler 32 (not shown). According to the embodiment shown in Fig. 3, the cryocooler 32 includes a cold head comprising one or more cooling stages 32a and 32b. Preferably, a first cooling stage 32a of the cold head is thermally connected to the thermal shield 33a, whereas a second cooling stage 32b of the cold head is thermally connected to the main magnet 17. In a preferred embodiment, the first cooling stage 32a provides a temperature level of about 50 K, whereas the second cooling stage 32b provides a temperature level of about 4 K. In "dry" magnetic resonance devices, the cooling stages 32a and 32b of the cryocooler 32 may be connected to components of the magnet support system 31 via solid thermal conductors 39a and 39b. It is also conceivable that the magnetic resonance device 11 comprises one or more small cryogen vessels (not shown) thermally connected to the cryocooler 32 via a solid thermal conductor, a heat pipe, and/or a convective loop. The one or more cryogen vessels may be thermally connected to the main magnet 17 via a heat exchanger and/or a solid thermal conductor 39.

During operation of the magnetic resonance device 11, the thermal shield 33a may be maintained at an intermediate temperature, e. g. between 40 K and 60 K, preferably about 50 K. The thermal shield 33a may comprise an electrically conductive material configured for shielding the main magnet 17 from blackbody radiation emitted in the region 72. The thermal shield 33a may be wrapped in an assembly of MLI blankets 44 (see Fig. 3) configured to provide a thermal insulation from the region 72. Preferably, at least one MLI patch of the assembly of MLI blankets may abut against the MLI wrapped around the suspension rod 12. The at least one MLI patch may be taped to the assembly of MLI blankets 44.

In an alternative embodiment, the thermal shield 33a and the main magnet 17 are thermally connected to the same stage of a cryocooler 32. It is also conceivable, that the thermal shield 33a and the main magnet 17 are connected to different or separate cryocoolers 32.

Fig. 3 shows a representation of an embodiment of the inventive magnet support system 31. In the depicted example, the suspension rod 12 interfaces with the outer vacuum chamber 42 via a bolt and a ferrule 55. The suspension rod 12 may be mechanically connected to the main magnet 17 (not depicted) in a similar fashion. Preferably, the suspension rod 12 is held under tension between the main magnet 17 and the outer vacuum chamber 42. The suspension rod 12 is attached to the outer vacuum chamber 42 at a room temperature side 70 of the magnet support system 31.

In the illustrated example, the thermal intercept 50 is located within a region 74 encompassed by the further thermal shield 33b. The further thermal shield 33b may represent a 4 K shield and the region 74 may represent a 4 K region of the magnet support system 31. The thermal intercept 50 is thermally and mechanically connected to the thermal shield 33a via the tubular thermal conductor 52 and the flexible thermal conductor 53. Thus, a temperature of the thermal intercept 50 may substantially correspond to a temperature of the thermal shield 33a. Preferably, the thermal shield 33a is thermally connected to the first stage 32a of the cryocooler 32 via a solid thermal conductor 39a (see Fig. 2). The thermal shield 33a may represent a 50 K shield and a region 73 between the thermal shield 33a and the further thermal shield 33b may represent an intermediate region.

In a preferred embodiment, the flexible thermal conductor 53 consists of a copper braid, which is soldered to the tubular thermal conductor 52. The tubular thermal conductor 52 may be implemented as a copper tube swaged and/or soldered to the suspension rod 12. Thus, the thermal intercept 50 is thermally connected to the thermal shield 33a via a thermal link provided by the copper tube 52 and the copper braid 53.

According to an embodiment, a thermally conductive adhesive 56 may be disposed within an interfacial region between the suspension rod 12 and the tubular thermal conductor 52. The thermally conductive adhesive 56 may be configured to improve a thermal contact, but also a mechanical bond, between the shaft of the suspension rod 12 and the tubular thermal conductor 52. Preferably, the thermally conductive adhesive comprises a thermally conductive epoxy resin. The thermally conductive adhesive may have a bond thickness of less than 1 mm. It is also conceivable, that a malleable metal, such as indium, lead, or a suitable alloy, is disposed within the interfacial region between the suspension rod 12 and the copper tube 52.

The material of the tubular thermal conductor 52 may affect a performance of the thermal intercept 50. Preferably, oxygen free (OF) or electrolytic touch pitch (ETP) copper having a thermal conductivity of approximately 500 ***W*/(*m*·*K*)** at 77 K is used. However, phosphorous deoxidized copper having a much lower thermal conductivity of approximately 120 ***W*/(*m*·*K*)** at 77 K and about 60 ***W*/(*m*·*K*)** at 30 K may be used as well. Although using a lower grade copper may change a thermal performance of the thermal intercept 50, an increase in the magnet heat load can be as low as 10 mW, which is acceptable for most applications. The material of the tubular thermal conductor 52 is not limited to copper. For instance, aluminium (e. g. AL1050 or AL6063 T5) also exhibits a sufficient thermal conductivity at low temperatures.

The flexible thermal conductor 53 may be attached to a surface of the thermal shield 33a facing a wall of the outer vacuum chamber 42. Preferably, the flexible thermal conductor 53 is attached to the thermal shield 33a via a rivet and/or a thermally conductive epoxy resin. It is conceivable that an additive configured to improve thermal contact and/or prevent cracking or fracturing of the thermal shield 33a and/or the flexible thermal conductor 53 is disposed within an interfacial region between the thermal shield 33a and the flexible thermal conductor 53.

A section of the suspension rod 12 may be wrapped in a thermally insulating material 54. For example, one or more blankets of multilayer insulation (MLI) may be wrapped around a shaft of the suspension rod 12 between the ferrule 55 and the thermal intercept 50. The MLI blankets may comprise any suitable shape, such as a rectangle shape, a triangular shape, or an oval shape. The MLI blankets may be butted and taped along butt seams with low emissivity tape. In a preferred embodiment, the MLI wrapping extends through the passage 60a in the thermal shield 33a.

The magnet support system 31 may further comprise an assembly of MLI blankets 44 covering the passage 60a in the thermal shield 33a, but also a surface of the thermal shield 33a. In particular, the assembly of MLI blankets 44 may comprise an MLI patch configured to conceal or occlude the passage 60a in the thermal shield 33a. The MLI patch may including a passage or conduct for the suspension rod 12. Low emissivity tape may be used to hold the MLI patch in place and to prevent thermal radiation from escaping through a gap between the thermal shield 33a and the suspension rod 12 from region 72. Thus, a high share of blackbody radiation emitted from the suspension rod 12 within the region 72 may be deflected or prevented from entering the regions 73 and/or 74.

As shown in Fig. 3, the suspension rod 12 may also comprise a collar 51. The collar 51 may comprise or consist of a thermally insulating material, such as MLI. Preferably, the collar 51 is wrapped in a thermally insulating material and taped to the tubular thermal conductor 52 using a high-emissivity tape. The collar 51 may comprise a tapering profile forming a plug. The suspension rod 12 and/or the collar 51 may be arranged relative to the further thermal shield 33b in such a way, that the collar 51 or plug occludes the passage 60b in the further thermal shield 33b. Thus, the collar 51 may prevent a high share of thermal radiation, particularly blackbody radiation, from passing through a gap between the suspension rod 12 and the thermal shield 33b and reaching the region 74.

According to the invention, heat energy transported through the suspension rod 12 to the main magnet 17 is effectively reduced by thermally intercepting the suspension rod 12 using a thermal intercept 50 and a thermal link (e. g. comprising a tubular thermal conductor 52 and a flexible thermal conductor 53) thermally and mechanically connected to the thermal shield 33a. A cooling capacity required for maintaining the main magnet 17 at a superconducting temperature may depend significantly on the location of the thermal intercept 50 along a shaft of the suspension rod 12. Preferably, the thermal intercept 50 should be located at a distance of more than 5 cm, more than 10 cm, more than 20 cm, or more than 30 cm to the room temperature side 70 of the suspension rod 12 to avoid excessive heat loads on the thermal shield 33a.

As can be appreciated from Figs. 2 and 3, the suspension rods 12 may need to be stowed in a position within the thermal shield 33a when loading the main magnet 17 into the outer vacuum chamber 42. This operation carries a risk of damaging the further thermal shield 33b which can be mitigated significantly via the inventive suspension rod 12 and the inventive magnet support system 31 providing a flexible thermal conductor 53 thermally connected to a rigid tubular thermal conductor 52 routed through the passage 60b in the further thermal shield 33b.

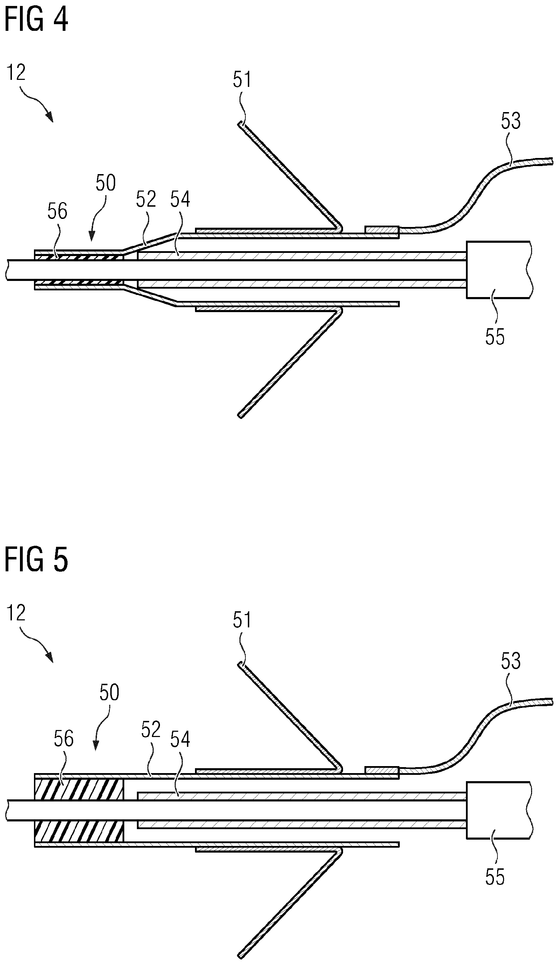

Fig. 4 shows a more detailed representation of an embodiment of the inventive suspension rod 12 as used in the magnet support system illustrated in Fig. 3. In the depicted example, the flexible thermal conductor 53 is soldered onto the tubular thermal conductor 52. The tubular thermal conductor 52 is swaged onto the shaft of the suspension rod 12 to form the thermal intercept 50. A thermally conductive adhesive and/or a malleable conductive metal may be disposed in an interfacial region between the tubular thermal conductor 52 and the shaft of the suspension rod 12.

Fig. 5 shows a representation of a further embodiment of the inventive suspension rod 12. In contrast to the embodiment illustrated in Figs. 3 and 4, the tubular thermal conductor 52 of the thermal intercept 50 is embodied as a straight metal tube (i. e. the tubular thermal conductor 52 is not swaged or crimped onto the suspension rod 12). The thermal and mechanical connection between the shaft of the suspension rod 12 and the tubular thermal conductor 52 is provided via a thicker layer of a thermally conductive adhesive 56, preferably a thermally conductive epoxy resin. The thermal performance (e. g. the thermal conduction and/or thermal transmittance) of the thermal intercept 50 may be controlled via a length, a thickness, and/or a thermal conductivity of the thermally conductive adhesive 56. According to an embodiment, the thermally conductive adhesive 56 is an epoxy resin having a thermal conductivity of 0.15 ***W*/(*m*·*K*),** a bond length of 25 mm and a thickness of 4 mm. Thus, a temperature difference of approximately 10 K across the layer of thermally conductive adhesive 56 may be achieved during operation of the inventive magnetic resonance device 11, which can be acceptable from cryogenic design considerations.

In using a straight tubular thermal conductor 52 and a thicker layer of thermally conductive adhesive 56, a swaging process may be avoided. Thus, the tubular thermal conductor 52 may favourably comprise a thicker wall, which reduces a thermal impedance in the tubular thermal conductor 52. As a further advantage, the tubular thermal conductor 52 may comprise or consist of a material which is difficult or impossible to swage or crimp.

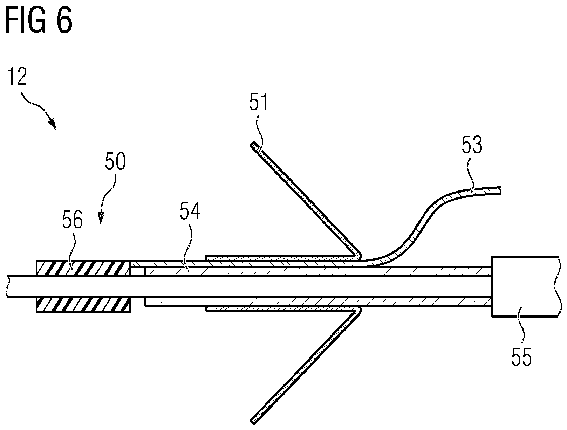

Fig. 6 illustrates a representation of a further embodiment of the inventive suspension rod 12. In the depicted example, a tubular thermal conductor 52 is omitted. The flexible thermal conductor 53, e. g. a copper braid, is bonded directly to the suspension rod 12 via the thermal intercept 50. The copper braid 53 is routed along a section of the suspension rod 12 located between the thermal intercept 50 and the ferrule 55. Particularly, the copper braid 53 is guided along a surface of the thermally insulating material 54 facing away from the shaft of the suspension rod 12. The thermally insulating material 54 may comprise of consist of one or more blankets of MLI wrapped around the shaft of the suspension rod 12.

According to an embodiment, the flexible thermal conductor 53 is supported or held in place by the collar 51 which is wrapped around the flexible thermal conductor 53 and taped in place with low emissivity tape. The thermally insulating material 54 provides a separation between the flexible thermal conductor 53 and the shaft of the suspension rod 12 and thermally insulates the flexible thermal conductor 53 from the shaft of the suspension rod 12. The suspension rod 12 shown in Fig. 6 may effectively prevent thermal radiation from entering the region 74. However, it may offer less protection of the flexible thermal conductor 53, particularly the mechanical connection between the flexible thermal conductor 53 and the thermal shield 33a during an assembly of the magnet support system 31 and/or the magnetic resonance device 11.

The embodiment of the suspensive rod 12 depicted in Fig. 6 may represent a particularly inexpensive way of spacing the flexible thermal conductor 53 from the suspension rod 12 along a section of the suspension rod 12 located between the thermal intercept 50 and the ferrule 55.

The embodiments described herein are to be recognized as examples. It is to be understood that individual embodiments may be extended by or combined with features of other embodiments if not stated otherwise.

## Claims

1. Suspension rod (12) for suspending a main magnet (17) of a magnetic resonance device (11), comprising a first end, a second end, and a thermal intercept (50) including a thermal link thermally and mechanically connected to the thermal intercept (50), wherein the thermal intercept (50) is configured for thermally connecting the suspension rod (12) to a cold source and wherein the thermal intercept (50) is thermally and mechanically connected to a section of the suspension rod (12) located between the first end and the second end, wherein the thermal link is spaced from the suspension rod (12) along a section of the suspension rod (12) located between the thermal intercept (50) and the second end.

2. Suspension rod (12) according to claim 1, wherein a section of the suspension rod (12) located between the thermal intercept (50) and the second end is wrapped in a thermally insulating material (54).

3. Suspension rod (12) according to one of the previous claims, wherein a thermally insulating material (54) is disposed between the thermal link and the suspension rod (12).

4. Suspension rod (12) according to one of the previous claims, wherein the thermal link comprises a flexible thermal conductor (53).

5. Suspension rod (12) according to claim 4, wherein the flexible thermal conductor (53) comprises a flexible metal fabric, preferably a metal braid, a metal mesh, or a metal weave.

6. Suspension rod (12) according to one of the claims 4 or 5, wherein the thermal link comprises tubular thermal conductor (52) circumferentially encompassing the suspension rod (12) along a section of the suspension rod (12) located between the thermal intercept (50) and the second end.

7. Suspension rod (12) according to claim 6, wherein the tubular thermal conductor (52) is mechanically connected to the thermal intercept (50) or forms a part of the thermal intercept (50) and wherein the flexible thermal conductor (53) is mechanically connected to the tubular thermal conductor (52).

8. Suspension rod (12) according to a previous claim, further comprising a collar (51) configured for deflecting thermal radiation, wherein the collar (51) circumferentially encompasses the suspension rod (12) along a section of the suspension rod (12) located between the thermal intercept (50) and the second end.

9. Suspension rod (12) according to claim 8, wherein the collar (51) encompasses the suspension rod (12) and the thermal link, particularly the tubular thermal conductor (52), along a section of the suspension rod (12) located between the thermal intercept (50) and the second end.

10. Magnet support system (31), comprising a suspension rod (12) according to one of the previous claims, a main magnet (17), a thermal shield (33a), and an outer vacuum chamber (42), wherein the first end of the suspension rod (12) is mechanically connected to the main magnet (17) and the second end of the suspension rod (12) is mechanically connected to an outer wall of the outer vacuum chamber (42) and wherein the suspension rod (12) is routed through a passage (60a) in the thermal shield (33a), wherein the thermal intercept (50) is mechanically connected to a section of the suspension rod (12) located between the first end of the suspension rod (12) and the thermal shield (33a) and wherein the thermal intercept (50) is mechanically and thermally connected to the thermal shield (33a) via the thermal link.

11. Magnet support system (31) according to claim 10, comprising a further thermal shield (33b) arranged between the main magnet (17) and the thermal shield (33a), wherein the suspension rod (12) is routed through a passage (60b) in the further thermal shield (33b).

12. Magnet support system (31) according to claim 11, comprising a suspension rod (12) according to one of the claims 8 or 9, wherein the collar (51) is configured to abut against the further thermal shield (33b) and cover a gap between the further thermal shield (33b) and the suspension rod (12).

13. Magnet support system (31) according to one of the claims 11 or 12, wherein the thermal intercept (50) is mechanically connected to a section of the suspension rod (12) located between the first end of the suspension rod (12) and the further thermal shield (33b).

14. Magnet support system (31) according to one of the claims 10 to 13, wherein a section of the suspension rod (12) located between the thermal intercept (50) and the second end is wrapped in a thermally insulating material (54) and wherein the section of the suspension rod (12) wrapped in the thermally insulating material (54) passes through the passage (60a) in the thermal shield (33a).

15. Magnetic resonance device (11), comprising a field generation unit including a magnet support system (31) according to one of the claims 10 to 14 and at least one cryocooler (32), wherein the at least one cryocooler (32) is thermally connected to the main magnet (17) and the thermal shield (33a) and configured to maintain the main magnet (17) and the thermal shield (33a) at different temperature levels.
